# EUROPEAN PATENT APPLICATION

(11) **EP 0 636 705 A2**
(43) Date of publication of application: **01.02.1995**
(21) Application number: 94111667.5
(22) Date of filing: 26.07.1994
(51) Int. Cl.: C23C 16/44, C30B 25/14

(54) **A vertical type vapor phase growth apparatus**

(30) Priority: 27.07.1993 JP 204703/93
(71) Applicant: SHIN-ETSU HANDOTAI COMPANY LIMITED, Chiyoda-ku Tokyo (JP)
(72) Inventor: Hitoshi Habuka, Gunma-Ken (JP); Masanori Mayuzumi, Annaka-shi Gunma-Ken (JP); Naoto Tate, Gunma-Ken (JP); Masatake Katayama, Gunma-Ken (JP)
(74) Representative: TER MEER - MÜLLER - STEINMEISTER & PARTNER

(57) **Abstract**

A vertical type vapor phase growth apparatus comprises a susceptor (14) on which semiconductor substrates (13) are placed, a high frequency heating coil(s) (15) to heat said semiconductor substrates (13) via said susceptor (14), a vertical nozzle(s) (17) for introducing the source gas for the vapor phase growth which stands through the center portion of said susceptor (14) and a belljar (11) which contains these components, wherein a gas flow controlling plate (21) which controls the flow of the source gas blown out from the gas blowout holes (17a) formed on the side surfaces of the nozzle(s) (17) is provided above the gas blowout holes (17a) in such a way that the flow controlling plate (21) covers at least as far as the centers of those semiconductor substrates (13) that are placed at the outer row of said susceptor (14).

## Description

### Background of the Invention

### Related Applications

This application claims the priority of Japanese Patent Application No.5-204703 filed on July 27, 1993, which is incorporated herein by reference.

### Field of the Invention

This invention relates to a vapor phase growth apparatus, and more precisely to a vertical type vapor phase growth apparatus used for the vapor phase growth of an epitaxial layer on a semiconductor substrate.

### The Prior Art

In semiconductor manufacturing processes, the technique utilizing the vapor phase reaction to grow semiconductor epitaxial layers on a semiconductor substrate is very important. Recent years, in addition to group IV element semiconductors (including Si and Ge), group III-V compound semiconductors (including GaAs, InP, GaP, GaAsP, AlGaP, AlGaAs, InGaAs and InGaP) and group II-VI compound semiconductors (including ZnS, ZnSe, ZnSSe, CdTe and CdS) are used to grow semiconductor epitaxial layers.

When conducting the vapor phase growth of epitaxial layers, horizontal type apparatus, vertical (or pancake) type apparatus, barrel (or cylindrical) type apparatus, etc., are used. Of these, the vertical type apparatus has the advantage of producing epitaxial growth layers with a uniform layer thickness.

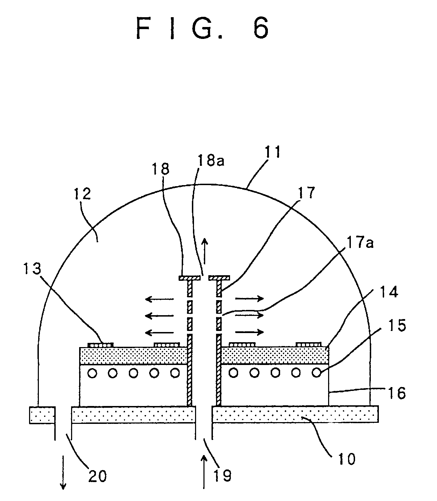

Figure 6 is a schematic cross section showing an example of a conventional vertical type vapor phase growth apparatus. In this vertical type vapor phase growth apparatus, a reaction chamber 12 is formed by placing a temple-bell-shape belljar 11 on a base plate 10. In this reaction chamber 12, a horizontal disk-shaped susceptor 14 on which semiconductor substrates 13 are placed is provided, and high frequency heating coil(s) 15 are provided in a coil cover 16 on the lower surface of the susceptor 14 to heat the semiconductor substrates 13 via the susceptor 14.

At the center of the reaction chamber 12, a tube-shaped nozzle 17 to introduce source gas for the vapor phase growth stands vertically through the susceptor 14. The top of the nozzle 17 is sealed by a plate 18, a large number of blowout holes 17a are provided on the side surface of the nozzle 17 to blow out the source gas along the surface of the susceptor 14, and a blowout hole(s) 18a is also provided on the plate 18 at the top of the nozzle 17.

The source gas is fed through the gas inlet port 19, and the main portion of it is blown out through the blowout holes 17a provided on the side surface of the nozzle 17, directed parallel to the main surface of the semiconductor substrates 13 into the reaction chamber 12, and discharged through the gas exhaust port(s) 20. Since the semiconductor substrates 13 are heated by the high frequency heating coil(s) 15, the source gas blown out over the semiconductor substrates 13 reacts on the semiconductor substrates 13, so that an epitaxial layer grows on each of the semiconductor substrates 13.

Such vertical type vapor phase growth apparatus has been disclosed in, for example, Japanese utility model unexamined publication (Jikkai) Sho 57-71337 and 59-151434.

However, when a semiconductor epitaxial layer was grown by using the conventional vertical type vapor phase growth apparatus such as the ones described above, the thickness of the epitaxial layer usually varied irregularly from batch to batch. Also, after removing and installing a nozzle 17 for routine cleaning, even if great care was taken to install the nozzle 17 to its exact original position, the in-plane distribution and the in-batch distribution of the epitaxial layer thickness could not be reproduced often, and in most cases the adjustment took a lot of time and work.

### Brief Summary of the Invention

An object of this invention is to provide a vertical type vapor phase growth apparatus which allows epitaxial layer thickness to be stable and reproducible at the in-plane distribution and in-batch distribution, as well as batch-to-batch distribution.

The aforementioned problems are solved by the vertical type vapor phase growth apparatus of this invention which comprises a susceptor on which semiconductor substrates are placed, a heating means to heat said semiconductor substrates via said susceptor, a vertical nozzle(s) for introducing source gas for the vapor phase growth which stands through the center portion of said susceptor and a belljar which contains these components, wherein a gas flow controlling plate which controls the flow of the source gas blown out from gas blowout holes is provided above said gas blowout holes formed on the side surface of said nozzle(s) in such a way that the gas flow controlling plate covers at least as far as the centers of those semiconductor substrates that are placed at the outer row on said susceptor.

Said gas flow controlling plate can be a flat plate parallel to said susceptor, a flat plate whose edge is sloped downward, or a curved plate whose center portion is convex upward.

The height h of said gas flow controlling plate measured from said susceptor is preferably half size or less than the radius R of said susceptor. It is also preferable to provide, on the top of said nozzle, a blowout hole(s) through which the source gas can be blown out upward.

In order to investigate the cause of the unstable thickness uniformity of the epitaxial layer formed by the vapor phase growth using conventional vertical type vapor phase growth apparatus, the inventors studied the flow pattern of the source gas in the reaction chamber of the verticl type vapor phase growth apparatus. Since the temperature of the belljar of the vertical type vapor phase growth apparatus was relatively low compared with that of the susceptor, the inventors suspected that there is an unstable gas convection above the susceptor due to a natural convection. The unstability of the thickness uniformity of the epitaxial layer is distinctly reflected by the gas flow pattern in the reaction chamber. An unstable gas flow can suffer stability and reproducibility of the thickness uniformity of the epitaxial layer.

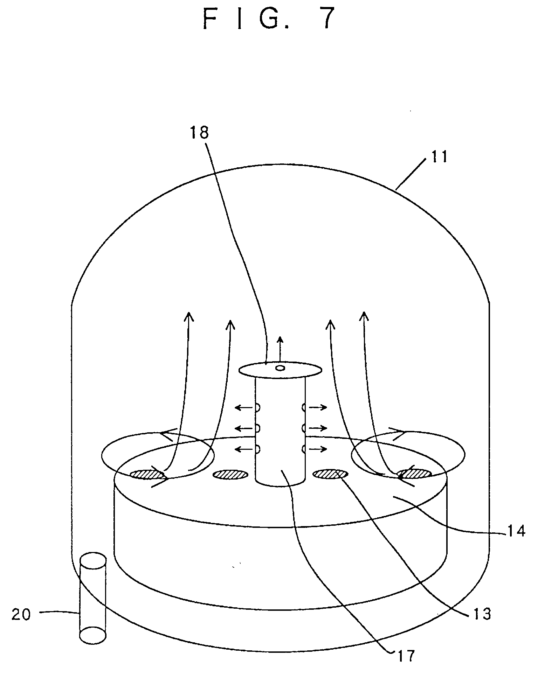

The inventors then generated white smoke comprising fine particles of silicon dioxide in the reaction chamber of a conventional vertical type vapor phase growth apparatus and observed the behavior of the gas flow. The observation showed that, as shown in Figure 7, the source gas blown out horizontally from the side surface of the nozzle 17 changed direction after it reached the inner wall of the belljar 11, flowed tangent to the susceptor 14 which was heated to a high temperature, and went back toward the nozzle 17. However, it was also observed that the source gas flowed upward during the process of reaching to the nozzle 17 because the buoyancy was given to the source gas by the heat from the high temperature susceptor.

Furthermore, the upward flow pattern of the source gas was not at all constant but quite irregular; in fact it hardly flowed upward in some cases. Such an instability of the source gas flow is believed to be the cause of the unstable thickness uniformity of the epitaxial layer.

One possible method to stabilize this flow pattern of the source gas would be to increase the blowout velocity of the source gas. In this method, the source gas is blown out at a flow velocity high enough to overcome the buoyancy generated by the heat from the susceptor, so as to prevent the source gas from changing in an upward direction. However, this method is not suitable because it requires a large amount of gas to flow, leading to a very low consumption efficiency of the source gas.

In this invention, a gas flow controlling plate is provided at a prescribed height on the nozzle in order to fundamentally block the upward flow path of the source gas. The gas flow controlling plate blocks the escaping upward flow path of the source gas, which has gained buoyancy from the heat of the high temperature susceptor, and thus prevents the source gas from dissipating into an area of the reaction chamber which is not involved in the epitaxial growth. Also, since the gas flow controlling plate restricts the degree of directional freedom of the source gas flow, the source gas flows in a predetermined path, thus creating a very stable gas flow above the semiconductor substrates. As a result, a very high stability and reproducibility of the layer thickness uniformity can be achieved when a semiconductor epitaxial layer is grown.

Further, when the source gas is blown upward from the blowout hole(s) on the top of the nozzle, if the flow rate of the source gas blown upward is high, the top half of the reaction chamber will have a relatively high pressure. A relatively high pressure in the top half of the reaction chamber in turn has the effect to make the source gas angle slightly lowered from horizontal angle at which the source gas is blown out from the side surface of the nozzle, thus reducing the ratio of the source gas escaping upward.

As a result, very high stability and reproducibility of the layer thickness uniformity can be achieved when a semiconductor epitaxial layer is grown.

### Brief Description of the Drawings

Figure 1 is a schematic cross section showing an example of a vertical type vapor phase growth apparatus of this invention.

Figure 2 is an illustrative figure showing the nozzle 17 and its surrounding area of the vertical type vapor phase growth apparatus shown in Figure 1.

Figure 3 is an illustrative figure showing the flow pattern of the source gas in the vertical type vapor phase growth apparatus shown in Figure 1.

Figure 4 is a graph showing the dispersion of the thickness of the epitaxial layers between batches of vapor phase growth.

Figure 5 is an illustrative figure showing the nozzle 17 and its surrounding area of another example of the vertical type vapor phase growth apparatus of this invention.

Figure 6 is a schematic cross section showing an example of a conventional vertical type vapor phase growth apparatus.

Figure 7 is an illustrative figure showing the flow pattern of the source gas in the vertical type vapor phase growth apparatus shown in Figure 6.

### Detailed Description

The function of the gas flow controlling plate of this invention is fundamentally different from that of the top plate 18 on the nozzle 17 of the conventional vertical type vapor phase growth apparatus shown in Figure 6. That is, the plate 18 in Figure 6 is simply for sealing the top of the nozzle 17. It is not for influencing the gas flow, and, in fact, it is provided in such a way that it does not make an influence on the gas flow. On the other hand, the gas flow controlling plate of this invention is for positively controlling the gas flow, and it is not necessarily provided only at the top of the nozzle.

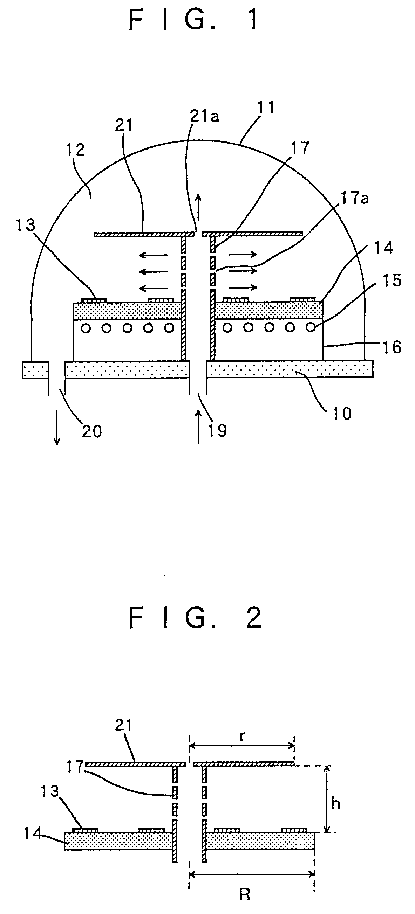

Vertical type vapor phase growth apparatus of this invention is described below by referring to drawings. Figure 1 shows a schematic cross section showing an example of a vertical type vapor phase growth apparatus of this invention. The vertical type vapor phase growth apparatus of this example has almost the same basic configuration as the conventional vertical type vapor phase growth apparatus shown in Figure 6. Therefore, in Figure 1, the portions which are identical to or the equivalent of their counterparts in Figure 6 are given the same symbols and a description of them is omitted.

In the vertical type vapor phase growth apparatus of this example, a disk-shape gas flow controlling plate 21 to control the flow of the source gas is provided at the top of the nozzle 17 for introducing the source gas. This gas flow controlling plate 21 is a flat plate set parallel to the susceptor 14. At the center of the gas flow controlling plate 21, a gas blowout hole 21a for blowing out the source gas upward is provided. Figure 2 shows the nozzle 17 and its surrounding area only.

In this example, it is sufficient if the height h of the gas flow controlling plate 21 measured from the susceptor 14 is high enough so that the gas flow controlling plate 21 is located higher than the gas blowout holes 17a formed on the side surface of the nozzle 17. The actual height h in this example is half size or less than the radius R of the susceptor 14. For the radius r of the gas flow controlling plate, it is sufficient if the plate 21 covers as far as the centers of those semiconductor substrates that are placed on the outer row of said susceptor. In the drawing, the dimension ratios between the parts do not necessarily reflect these conditions.

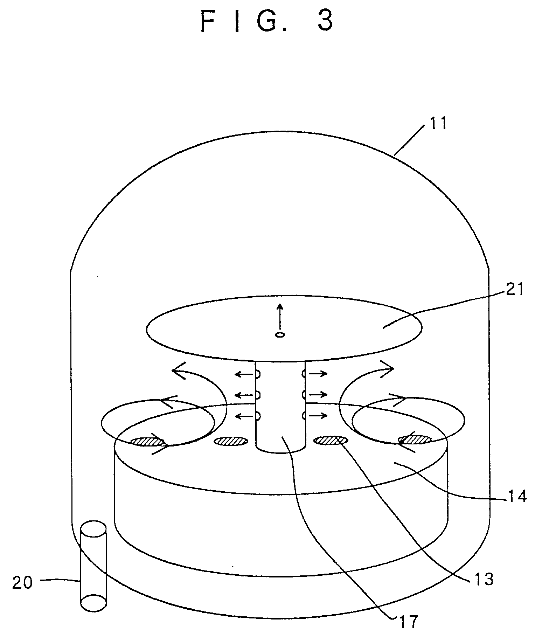

Figure 3 shows the flow pattern of the source gas in the vertical type vapor phase growth apparatus of this example. Although the source gas receives heat from the high temperature susceptor 14 and gains buoyancy, it is blocked by the gas flow controlling plate 21 and unable to escape upward.

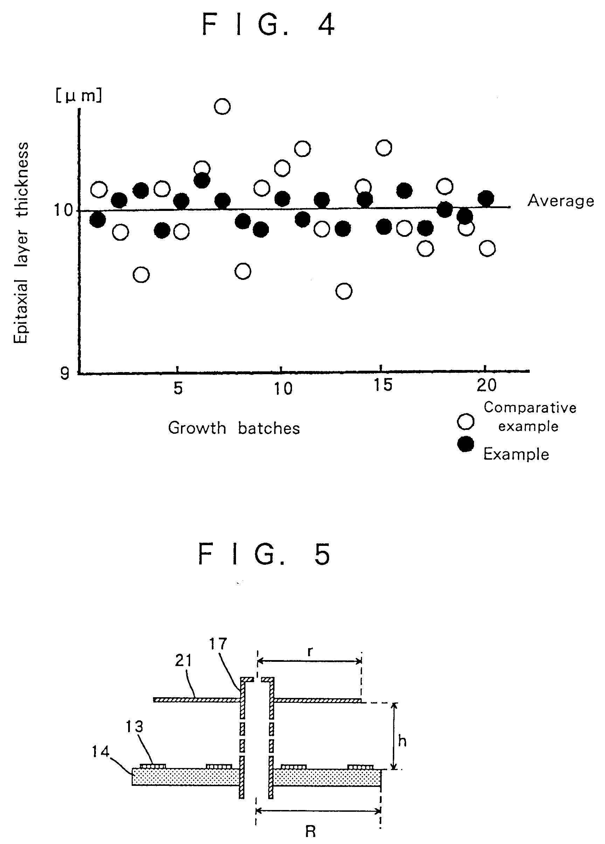

In the vertical type vapor phase growth apparatus of this example, using SiHCl₃ for example, diluted in hydrogen gas, a series of batch treatment process was conducted to grow a Si epitaxial layer on each of Si crystal substrates. And the thickness dispersion of the epitaxial layers within a batch was evaluated. The belljar 26 of the apparatus used here had a radius of 26 cm, the radius R of the susceptor was 23 cm, the radius r of the gas flow controlling plate 21 was 20 cm, and the height h of the gas flow controlling plate 21 measured from the susceptor 14 was a half size of the radius R of the susceptor 14. The flow rate of the hydrogen gas was 40 liters/minute. The results are shown in Figure 4, along with the results for a conventional vertical type vapor phase growth apparatus.

As shown in Figure 4, when the conventional apparatus is used, the thickness dispersion of the silicon epitaxial layers shows irregular and unstable fluctuations between batch to batch. When the apparatus of this example is used, the amplitude of the fluctuations is reduced to 1/2-1/3 of the amplitude for the conventional system.

The radius r of the gas flow controlling plate 21 is determined by the flow rate and flow velocity of the source gas blown out horizontally from the side surfaces of the nozzle 17. When the flow velocity and flow rate of the source gas blown out horizontally is high, the degree of gas flow deflection caused by the buoyancy is small, hence the radius r of the gas flow controlling plate 21 can be smaller. On the other hand, when the flow velocity and flow rate of the source gas blown out horizontally is low, the degree of the gas flow deflection caused by the buoyancy becomes greater, hence it becomes necessary to make the radius r of the gas flow controlling plate 21 larger so that the area for blocking the upward movement of the source gas is wider.

As described above, the radius r of the gas flow controlling plate 21 is determined by the conditions of the vapor phase growth. According to experiments, it is sufficient if the plate covers at least as far as the centers of the semiconductor substrates that are placed on the outer row of the susceptor 14. It is not necessary for the gas flow controlling plate 21 to cover beyond the radius R of the susceptor 14. The height h of the gas flow controlling plate 21 measured from the susceptor 14 must be set at half size or less than the radius R of the susceptor 14. If h is larger than that, then there will be an unstable natural convection in the space between the gas flow controlling plate 21 and the susceptor 14.

Figure 5 shows the nozzle 17 and the surrounding area of another example of the vertical type vapor phase growth apparatus of this invention. In this example, the gas flow controlling plate 21 is provided at a level lower than the top of the nozzle 17. In other words, the gas flow controlling plate 21 is not necessarily provided only at the top of the nozzle 17, as in the first example, and it can be set at any desired height so that the flow of the source gas can be satisfactorily controlled.

A reduction in defects (such as protruding defect which were conventionally seen on the epitaxial layer surface) was observed as a secondary effect of the presence of the gas flow controlling plate 21. The mechanism of the generation of such a defect is believed to be as follows: chemical material(s) (intermediate product(s)) which are generated during the chemical reaction for the epitaxial growth is carried upward by the gas flow and cooled down, resulting in formation of fine particles due to condensation/nucleation, and these fine particles fall on and stick to the semiconductor substrates. It is believed, however, that when the gas flow controlling plate 21 is provided, the upward movement of said chemical material is blocked, and formation of the fine particles is suppressed.

Thus far, examples of this invention are described in detail. Needless to say, however, this invention is not limited to the examples described above and various changes are possible. For example, although the gas flow controlling plate is disk-shape in the examples described above, the same effect can obviously be achieved by using a polygonal plate instead of a disk, and the polygon can be either equilateral or non-equilateral.

In the examples described above, the gas flow controlling plate is a flat plate provided parallel to the susceptor. However, the shape of the gas flow controlling plate can be those with a slope, such as an umbrella-shape, dome-shape or cup-shape. It will be more effective if the shape is adopted by corresponding to the gas flow pattern in the reaction chamber 12. For example, the gas flow observation described above revealed that, depending on the number and the placement of the gas exhaust ports 20, the gas flow in the reaction chamber 12 can be asymmetrical with respect to the center, and therefore, depending on how the gas flows in the reaction chamber 20, it may be more effective if the entire gas flow controlling plate 21 is lowered or raised on the side of the gas exhaust ports. For example, when only one gas exhaust is provided on the base plate 10, the side of the gas exhaust port 20 can be lowered or raised.

The orientation and angle of the slanting of the gas flow controlling plate can be determined based on the fluctuation and distribution of the gas flow conditions and the growth rate which vary depending on the gas flow rate, the growth temperature and the type of gas. Also, in addition to slanting the entire gas flow controlling plate 21, another effective method is to extend or shorten the gas flow controlling plate 21 in the direction of the gas exhaust port.

Various shapes can be adopted for the shape of the gas blowout holes, including circles, ellipses, ovals, rectangles, grooves, etc. The material of the nozzle can be quartz glass, silicon carbide, silicon nitride, steel, iron, titanium, etc., and it can be selected according to the optimal temperature of the growth of the epitaxial layers.

In the examples described above, the silicon epitaxial layer is grown by using SiHCl₃ as the source gas. It is also possible by using the vertical type vapor phase growth apparatus described above to grow semiconductor epitaxial layers composed of group IV semiconductors (such as Ge), group III-V compound semiconductors (such as GaAs, InP, GaP, GaAsP, AlGaP, AlGaAs, InGaAs and InGaP), and group II-VI compound semiconductors (such as ZnS, ZnSe, ZnSSe, CdTe and CdS, etc.)

As described thus far, this invention allows for the growth of epitaxial crystal layers with a uniform thickness and good reproducibility.

## Claims

1. A verticalt type vapor phase growth apparatus comprising a susceptor (14) on which semiconductor substrates (13) are placed, a heating means (15) to heat said semiconductor substrates (13) via said susceptor (14), a vertical nozzle(s) (17) for introducing the source gas for the vapor phase growth which stands through the center portion of said susceptor (14) and a belljar (11) which contains these components, wherein:
the vapor phase growth of a semiconductor epitaxial layer(s) on said semiconductor substrates (13) is conducted by blowing out the source gas for the vapor phase growth from gas blowout holes (17a) formed on the side surface of said nozzle (17); and
a gas flow controlling plate (21) which controls the flow of the source gas blown out from said gas blowout holes (17a) is provided above said gas blowout holes (17a) formed on said side surface of said nozzle(s) (17) in such a way that the flow controlling plate (21) covers at least as far as the centers of those semiconductor substrates (13) that are placed at the outer row on said susceptor (14).

2. A vertical type vapor phase growth apparatus as described in Claim 1 wherein:
said gas flow controlling plate (21) is a flat plate parallel to said susceptor (14).

3. A vertical type vapor phase growth apparatus as described in Claim 1 wherein:
said gas flow controlling plate (21) is a flat plate whose edge is sloped downward.

4. A vertical type vapor phase growth apparatus as described in Claim 1 wherein:
said gas flow controlling plate (21) is a curved plate whose center portion is convex upward.

5. A vertical type vapor phase growth apparatus as described in Claim 1 or 2 wherein:
the height (h) of said gas flow controlling plate (21) measured from said susceptor (14) is half size or less of the radius (R) of said susceptor (14).

6. A vertical type vapor phase growth apparatus as described in Claim 1, 2 or 5 wherein:
a blowout hole(s) (21a) through which the source gas can be blown out upward is provided on the top of said nozzle (17).
